Europäisches Patentamt

European Patent Office

Office européen des brevets

(11) Publication number: **0 596 592 A2**

## EUROPEAN PATENT APPLICATION

(21) Application number: **93306235.8**

(22) Date of filing: **06.08.93**

(51) Int. Cl.5: **H01L  21/90**, H01L  21/3205

(30) Priority: **21.09.92 US 948047**

(43) Date of publication of application:
**11.05.94 Bulletin  94/19**

(84) Designated Contracting States:
**BE DE DK ES FR GB GR IE IT LU NL PT**

(71) Applicant: **ADVANCED MICRO DEVICES, INC.**
**901 Thompson Place**
**P.O. Box 3453**
**Sunnyvale, CA 94088(US)**

(72) Inventor: **Tsiang, Jerry H.**
**1038 Pennington Lane**
**Cupertino, California 95014(US)**
Inventor: **Peng, Yeng-Kaung**
**18408 Swarthmore Drive**
**Saratoga, California 95070(US)**
Inventor: **Shiau, Ying**
**1556 Oak Canyon Drive**
**San Jose, California 95210(US)**
Inventor: **Ma, Ann**
**680 Covington Road**
**Los Altos, California 95024(US)**

(74) Representative: **Sanders, Peter Colin**
**Christopher et al**
**BROOKES & MARTIN**
**High Holborn House**
**52/54 High Holborn**
**London WC1V 6SE (GB)**

(54) **Method for the elimination of metal voids in metal lines of a semiconductor device.**

(57) A method for minimizing metal voids in the metal lines during the manufacture of an semiconductor integrated circuit is described that has significant advantages over previously known methods. The method provides for the use of a nonreactive protective film that is wrapped around the metal lines to prevent the voids. In so doing, the reliability and strength of the electrical connections are significantly improved.

**FIELD OF THE INVENTION**

The present invention relates to the formation of metal lines within a semiconductor device and more particularly eliminating voids in metal lines formed therewithin.

**BACKGROUND OF THE INVENTION**

There are many metal connections made in semiconductor integrated circuits. In integrated circuit technology as the size of the circuit becomes smaller and smaller, the corresponding lines become smaller and in turn the number of lines within the circuit becomes higher. Particularly, as more and more functionality is provided into a smaller and smaller package, the number of metal lines becomes exponentially higher. For example, in a microprocessor they may be millions of metal lines that correspond to the different connections that are required between the different electrical components located therewithin.

Voids in the metal lines have been in existence for a significant period of time. However, in the past, the metal lines were very wide compared to the size of the metal void. For example, approximately ten years ago, a ten (10) micron semiconductor process was typically used to manufacture semiconductors integrated circuits. For such processing widths, the voids created were very small compared to the width of the metal lines.

Approximately five years ago, the typical semiconductor process was a one (1) micron process and the void problem became more pronounced. However even at this width there was not a significant problems with voids. However, today typically the semiconductor process can be as small as six tenths ( .6) micron. At this width or smaller the voids become a significant problem. At these widths the voids can be as large as the width of the metal lines thereby causing discontinuities and high resistance connections within the device. As the technology migrates down to a smaller and smaller process this void issues can become very significant.

It has been found that the void problem is particularly acute when forming metal lines of aluminum in a semiconductor circuit. What is needed therefor is a method for minimizing the voids that are produced by prior art semiconductor processing techniques. More particularly, what is needed is a method for eliminating the void problems in all kinds of semiconductor devices that use aluminum as the conducting material. The method should be one that is reliable and one which will not appreciable increase the cost of semiconductor manufacturing.

A method for minimizing metal voids and metal lines in a semiconductor circuit is disclosed. The method comprises the steps of depositing a protective film on the semiconductor layer, providing a metal layer on the protective film, etching the metal layer to form a plurality of metal lines thereon, depositing the protective film on the metal line, such that the metal lines are separated from the surrounding dielectric. The protective film is such it is nonreactive with the metal layer and the surrounding dielectric. The protective film is then removed substantially from all areas of the semiconductor device except the area around the metal lines.

In the accompanying drawings, by way of example only:

Figure 1 is a representation of a void in a metal line in which the metal line is approximately ten (10) microns in width.

Figure 2 is a representation of a void in a metal line in which the metal line is six-tenths (.6) microns in width.

Figure 3 is a cut-away view of the void shown in Figure 2.

Figure 4 is a cross-sectional representation of a semiconductor device in accordance with the prior art.

Figure 5 is a cross-sectional representation of a semiconductor device embodying the present invention.

As has been before mentioned there is a concern about the formation of metal voids in an integrated circuit processing due to stress on the metal. The applicants have studied the source of this stress thoroughly and have postulated a reason for the metal voids that has been substantiated in practical circumstances. To more fully understand the problems associated with metal voids in a semiconductor metal layer refer now to the following discussion.

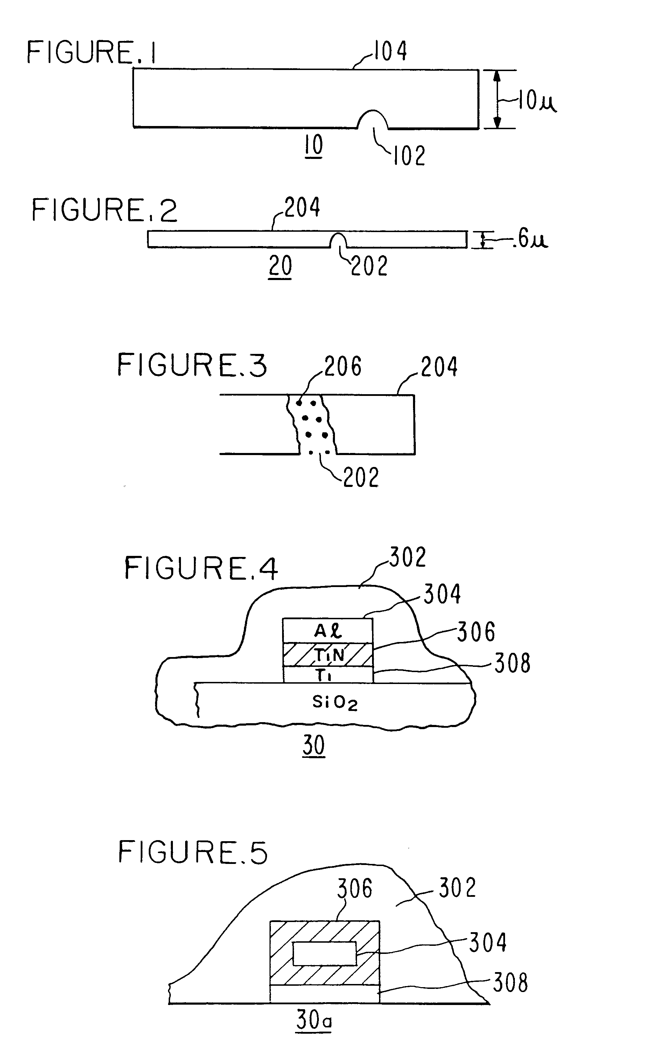

To more specifically understand this problem, refer now to Figures 1 and 2 which show in representational form a metal line 10 from a ten (10) micron width process and a metal line 20 from a six-tenths (.6) micron width, respectively. The metal lines shown are for illustrative purposes only and are not in scale. As is seen in Figure 1, the metal void 102 that is present on a ten (10) micron process is very small relative to the width of the metal line 104. Therefore, although there is a void 102 it does not affect the conductivity of the metal line 104 because the line 104 itself is so wide.

Referring now to Figure 2 shown is a metal line 204 made from the six-tenths (.6) micron process and as can be seen the void 202 can cause a discontinuity in the metal line 204 and thereby create high resistance connections. To facilitate understanding, the present invention will be discussed in terms of a particular metal (aluminum), a particular semiconductor layer (silicon), a particular barrier material (TiN) and a particular dielectric material (silicon dioxide). It should be understood by one of ordinary skill in the art that many other elements can be substituted for those above mentioned and their use would be within the spirit and scope of the present invention.

Referring now to Figure 3 which is a cut away version of the void 202 in the metal line 204. It has been found that this void contains a larger concentration of silicon 206 than would be expected ordinarily. The reasons for this will be discussed in detail later in this specification.

Referring now to Figure 4, what is shown is a cross sectional view of a typical semiconductor substrate 30. It should be recognized that this view is not in scale. A dielectric material such as silicon dioxide ($SiO_2$) forms the bottom surface and also the top surface of the substrate 30. In between those surfaces are a barrier metal [for example titanium (Ti)] 308, a titanium nitride layer 306 and aluminum line 304.

To more fully understand how this type of semiconductor structure is formed refer now to the following discussion. During metal processing, a barrier material is deposited first, in this case titanium and titanium nitride. Thereafter, a metal such as aluminum is deposited on top of the barrier material. Thereafter the aluminum is etched to define the various metal lines on the semiconductor surface.

Since silicon dioxide is deposited on top of metal lines, it has been found with this type of process that stresses occur that cause the formation of metal voids. It is applicant's discovery that the formation of that metal voids is due to the reaction between the aluminum and its surrounding passivation/top side layer, silicon dioxide $SiO_2$.

The following equation describes the chemical reaction that occurs between the aluminum and the silicon dioxide:

$$4\ Al\ +\ 3\ SiO_2\ =\ 2\ Al_2O_3\ +\ 3\ Si.$$

From this reaction it can be seen why aluminum is missing. As can be seen the metal voids are caused by a percentage of aluminum being absorbed and changed into aluminum oxide $Al_2O_3$.

To further prove this theory this reaction can be discussed from a thermodynamic point of view. The Gibbs Free Energy change is a well known principle that describes the change in energy based on reactions of different element compounds coming into the contact with each other.

Accordingly, the free energy change at 25°C between these elements can be described by:

$$\Delta F = 3\Delta F\ (Si)\ +\ 2\Delta F(Al_2O_3)\ -\ 4\Delta F(Al)\ -\ 3\Delta F(SiO_2)$$

$$= 3\ x\ 0 + 2\ x\ \ (-376.77)\ -\ 4\ x\ 0\ -\ 3\ x\ (-192.1)$$

$$= -177.24\ Kcal.$$

As is well known a negative number such as the above indicates that the reaction between aluminum and silicon dioxide is a spontaneous reaction. Therefore the reaction can occur at room temperature (25°C). Hence it is very clear that at the elevated temperatures that occur in semiconductor processes the formation of metal voids can be accelerated. Accordingly, the above mentioned reaction will occur at a wide temperature range. However, the reaction will be much faster at a higher temperature hence the void problems associated with smaller semiconductor processing technologies will be more serious at higher temperatures.

In addition it has been found by the applicants that the Molar Volume of the metal lines and its surrounding dielectric also decreases after the reaction takes place.

$$\Delta V = 3 \ V(Si) \ + \ 2 \ V(Al_2O_3) \ - \ 4 \ V(Al) \ - \ 3 \ V(SiO_2)$$

$$= 3x(28.1/2.32) + 2x(102/3.965) - 4x(27/2.70) -$$

$$3x(60.1/2,20)$$

$$= -34.12 \ ml$$

The above equation indicates that there will be a decrease of 34.12 milliliters after this kind of reaction. This decrease represent 28% of the total volume change. Accordingly metal will be missing because of the formation of aluminum oxide and silicon which has less volume than that of aluminum and silicon dioxide. As has been before mentioned it has been found by analysis that voids contains a disproportionate amount of silicon. This would indicate that the reaction is taking place.

Since the thermal expansion coefficients of aluminum and silicon dioxide have one order of magnitude difference, the increase in temperature will cause an increase in stress (equilibrium is disturbed), therefore more aluminum will react with silicon dioxide to form silicon and aluminum oxide (having less volume) to counteract the disturbance within the system. Therefor, as has above mentioned there will be extensive voids.

As has been above mentioned the metal voids are unavoidable in the traditional metal process and become very significant as the lines become thinner and thinner in the processing techniques. Accordingly what is needed and what the present invention addresses is the elimination of the metal voids associated with the prior art processing techniques. The applicants believe that by coating aluminum with a thin film of nonreactive material the reaction between the aluminum and its surrounding silicon dioxide barrier can be eliminated.

Referring now to Figure 5 what is shown is a cross-sectional view of a semiconductor device in accordance with the present invention. It should be recognized that this view is not in scale. As is seen, the metal line 304 is completely wrapped by a protective film. The composition of this protective film 304 should not react with the dielectric layer ($SiO_2$) and metal layer (Al). In addition, the thermal expansion coefficient of the film should be between that of aluminum and the silicon dioxide. It has been found that many metal films have been examined based on there thermodynamic properties including but not limited to TiN and Tungsten would be able to act as a protective film.

The process for forming the structure 30 comprises: providing metal layer on the protective film, etching the metal layer to form a plurality of metal lines, depositing the protective film on top of the metal lines such that the metal lines are separated from the semiconductor layer and the surrounding dielectric. The film as has been above mentioned is nonreactive with the metal layer and the surrounding dielectric layer. And finally removing the protective film from substantially all areas except the area around the metal lines. In so doing, the formation of metal voids due to the chemical reaction between metal and dielectric layer is avoided.

Although the present invention has been described in accordance with a specific embodiment of aluminum shown in the figures and the dielectric layer is has been referred to as a silicon dioxide layer it should be clear to one of ordinary skill in the art that there could be variations to this embodiment and that variation would be within the spirit and scope of the present invention. Accordingly, many modifications may be made by one of ordinary skill in the art without departing from the spirit and scope of the invention, the scope of which is defined solely be the appended claims.

**Claims**

1. A method for minimizing metal voids in the metal lines in a semiconductor integrated circuit, the integrated circuit including a surrounding dielectric layer and a protective film on a portion of the semiconductor layer, the method comprising the steps of:

    (a) providing a metal layer on the protective film;

    (b) etching the metal layer to form a plurality of metal lines;

    (c) depositing the protective film on the metal lines such the metal lines are separated from the surrounding dielectric material, the protective film being such that it is nonreactive with the metal layer and the surrounding dielectric material, and

    (d) removing the protective film from substantially all areas of the integrated circuit except the area around the metal lines.

4

2. The method of claim 1 in which the dielectric layer comprises silicon dioxide ($SiO_2$).

3. The method of claim 1 in which the semiconductor layer comprises silicon (Si).

4. The method of claim 1 in which the metal layer comprises aluminum.

5. The method of claim 1 in which the method further comprises processing the integrated circuit at a temperature between 400°C to 500°C.

FIGURE.1

104
10μ
10
102

FIGURE.2

204
.6μ
20
202

FIGURE.3

206
204
202

FIGURE.4

302
304
306
308
$Al$
$TiN$
$Ti$
$SiO_2$
30

FIGURE.5

306
302
304
308
30a